# EUROPEAN PATENT APPLICATION

(11) **EP 2 461 171 A2**
(43) Date of publication of application: **06.06.2012**
(21) Application number: 11191839.7
(22) Date of filing: 05.12.2011
(51) Int. Cl.: G01R 31/26, G01J 1/04

(54) **Tray, LED testing apparatus and testing method using the same**

(30) Priority: 03.12.2010 KR 20100123040
(71) Applicant: Samsung LED Co., Ltd., Yongi-City, Gyeonggi-Do (KR)
(72) Inventor: Yoo, Cheol Jun, Chungcheongnam-do (KR); Song, Young Hee, Gyeonggi-do (KR); Hwang, Seong Deok, Seoul (KR)
(74) Representative: Grünecker, Kinkeldey, Stockmair & Schwanhäusser

(57) **Abstract**

A tray, a testing apparatus and a testing method using the same are disclosed. The testing apparatus includes a tray (13) having a purality of light sources (11) received therein, the purality of light sources such as light emitting diodes, LEDs outputting light when power is applied thereto; a plurality of optical receiver units (15) arranged to correspond to the plurality of light sources (11) and receiving the light outputted from each of the plurality of light sources (11); a plurality of probe units (14) arranged to correspond to the plurality of light sources (11) and applying power to each of the plurality of light sources (11); a power supply control unit (18) selectively controlling power applied to the plurality of probe units (14); and an optical properties analyzing unit (19) analyzing properties of optical signals from the light received by the optical receiver units.

## Description

### CROSS-REFERENCE TO RELATED APPLICATIONS

This application claims the priority of Korean Patent Application No. 10-2010-0123040 filed on December 3, 2010, in the Korean Intellectual Property Office, the disclosure of which is incorporated herein by reference.

### BACKGROUND OF THE INVENTION

### Field of the Invention

The present invention relates to a tray, a testing apparatus and a testing method using the same.

### Description of the Related Art

Methods for testing the characteristics of a semiconductor package according to the related art are carried out by transferring individual semiconductor packages contained on a tray to testing sockets to perform testing thereupon, and then transferring the tested semiconductor packages to the tray again, according to quality classification. Thus, in the methods for testing the characteristics of a semiconductor package according to the related art, an expensive testing socket needs to be provided for each semiconductor package, and the semiconductor package on the tray needs to be transferred to the testing socket in order to perform testing on the semiconductor package, thereby resulting in a nonproductive process.

In addition, in the case of testing an LED package, a single integrated sphere is provided, and light sources are positioned below the integrated sphere. Through the arrangement of the integrated sphere (measuring device) and the LED package, and the vertical movement of the integrated sphere or the LED package, the integrated sphere is coupled with the LED package, thereby performing measurement thereupon. In this manner, a mechanical operation is carried out for each LED package, and the amount of time required for the measurement is increased.

Therefore, in order to efficiently respond to mass production, a tray design capable of improving measuring capability per unit time, a testing apparatus and a testing method using the same are required.

### SUMMARY OF THE INVENTION

An aspect of the present invention provides a tray capable of testing a subject directly on a tray, a testing apparatus and a testing method capable of improving testing capability per unit time using the tray.

An aspect of the present invention also provides a testing appratus, including: a tray having a purality of light sources received therein, the purality of light sources outputting light when power is applied thereto; a plurality of optical receiver units arranged to correspond to the plurality of light sources and receiving the light outputted from each of the plurality of light sources; a plurality of probe units arranged to correspond to the plurality of light sources and applying power to each of the plurality of light sources; a power supply control unit selectively controlling power applied to the plurality of probe units; and an optical properties analyzing unit analyzing properties of optical signals from the light received by the optical receiver units.

The power supply control unit may control power such that the power is applied to each of the plurality of light sources at different intervals of time.

The optical properties analyzing unit may discriminate and recognize a corresponding light source by an interval of time at which light is received.

The probe unit and the optical receiver unit may be integrated.

The testing apparatus may further include a classifier unit discriminating and arranging the plurality of light sources based on results analyzed from the the optical properties analyzing unit.

The testing apparatus may further include an integrating sphere collecting the light received from the optical receiver unit to guide the collected light to the optical properties analyzing unit.

The light received from the optical receiver unit may be guided to the integrating sphere.

The optical receiver unit may include a reflecting part upwardly reflecting light coming into contact with at least a partial area on an upper surface of each light source to be emitted from the light source, and an optical fiber part guiding the light reflected from the reflecting part.

The reflecting part may be formed of an optical fiber and integrated with the optical fiber part.

The probe units may come into contact with the light sources to apply power thereto.

The tray may include conductive connection parts corresponding to the received light sources and electrically connected to the light sources.

The probe units may come into contact with the conductive connection parts to apply power to the light sources.

The tray may include through holes penetrating at least portions of areas in which light sources received in the tray are seated, in a thickness direction thereof.

The probe units may come into contact with the light sources to apply power thereto through the through holes.

The light sources may be LED packages.

The light sources may be LED package modules in which LED packages are mounted on circuit boards.

According to an aspect of the present invention, there is provided a testing method, including: receiving one or more light sources in a tray; electrically connecting probe units arranged to correspond to the light sources; applying power to the light sources by the probe units; receiving optical signals from the light sources by optical signal units arranged to correspond to the light sources; and analyzing properties of the received optical signals.

The testing method may further include classifying the light sources by discriminating and arranging the light sources based on results analyzed from the the optical properties analyzing unit.

In the applying of power to the light sources, the power may be applied to each of the plurality of light sources at different intervals of time.

The intervals of time at which the power is applied to the each of the plurality of light sources may be sequential and sucessive.

In the receiving of the optical signals, a corresponding light source may be discriminated and recognized by an interval of time at which each of the optical signals is received.

According to another aspect of the present invention, there is provided a tray including: a body; a receiving part formed to be recessed inwardly from a surface of the body and receiving at least one semiconductor package therein; and a through hole formed to penetrate the body in a thickness direction thereof at a portional area of the receiving part, and exposing at least a portion of the semiconductor package towards the other surface of the body.

The semiconductor package may include a solder ball and have a through hole formed therein such that at least a portion of the solder ball is inserted into the body.

According to another aspect of the present invention, there is provided a tray including: a body; a receiving part formed to be recessed inwardly from one surface of the body to receive at least one semiconductor package therein, and including a bottom surface in which the semiconductor package is seated and side surfaces extended from the bottom surface; and inclined parts connecting the bottom surface with the side surfaces and having a width narrowing downwardly, such that the semiconductor package is fit-fixed therein.

According to another aspect of the present invention, there is provided a tray including: a body; a receiving part formed to be recessed inwardly from a surface of the body and receiving at least one semiconductor package therein; and a fixing element included within the receiving part to vacumm adhere and fix a surface of the semiconductor package.

According to another aspect of the present invention, there is provided a tray including: a body; a receiving part formed to be recessed inwardly from a surface of the body and receiving at least one semiconductor package therein; and a fixing element included over the receiving part to pressurize and fix the semiconductor package to the body.

The fixing element may have an impact absorbing layer formed on a portion thereof in contact with the semiconductor package.

### BRIEF DESCRIPTION OF THE DRAWINGS

The above and other aspects, features and other advantages of the present invention will be more clearly understood from the following detailed description taken in conjunction with the accompanying drawings, in which:
FIG. 1 is a block diagram schematically illustrating a testing apparatus according to an exemplary embodiment of the present invention;
FIGS. 2 through 6 are cross sectional views schematically illustrating various embodiments for the constitution of probe units and trays, in the testing apparatus according to the exemplary embodiment of the present invention;
FIGS. 7 and 8 are cross sectional views schematically illustrating the structures of optical receiver units receiving light generated from light sources, according to exemplary embodiments of the present invention;
FIG. 9 is a block diagram schematically illustrating a process in which an optical signal received by the optical receiver unit is guided to an optical properties analyzing unit, in the testing apparatus according to the exemplary embodiment of the present invention; and
FIGS. 10 through 15 are cross sectional views schematically illustrating the structures of trays according to exemplary embodiments of the present invention.

### DETAILED DESCRIPTION OF THE PREFERRED EMBODIMENT

Exemplary embodiments of the present invention will now be described in detail with reference to the accompanying drawings. The invention may, however, be embodied in many different forms and should not be construed as being limited to the embodiments set forth herein. Rather, these embodiments are provided so that this disclosure will be thorough and complete, and will fully convey the scope of the invention to those skilled in the art. The same or equivalent elements are referred to by the same reference numerals throughout the specification.

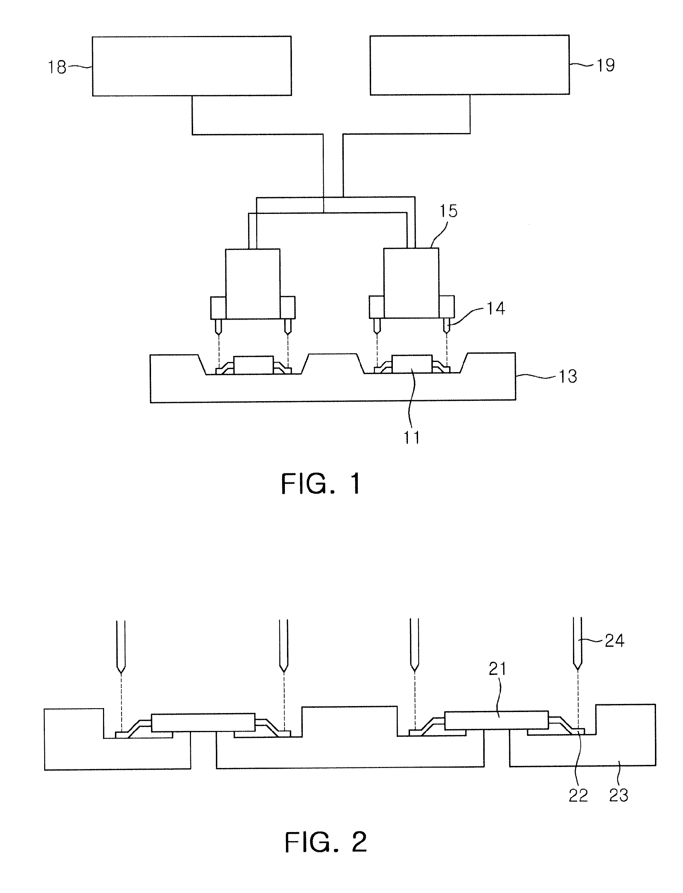

FIG. 1 is a block diagram schematically illustrating a testing apparatus according to an exemplary embodiment of the present invention.

Referring to FIG. 1, a testing apparatus according to the exemplary embodiment of the present invention may include a tray 13 in which a plurality of light sources 11 are received, a plurality of optical receiver units 15 arranged to correspond to the plurality of light sources 11 and receiving optical signals from each of the plurality of light sources 11, a plurality of probe units 14 arranged to correspond to the plurality of light sources 11 and applying power supply to each of the plurality of light sources 11, a power supply control unit 18 controlling power applied to the plurality of probe units 14, and an optical properties analyzing unit 19 analyzing the properties of the optical signals received by the optical receiver unit 15.

In addition, though not illustrated, the testing apparatus may further include a classifier unit discriminating and arranging the plurality of light sources based on results analyzed from the the optical properties analyzing unit 19. Further, the testing apparatus may further include a separate constituent capable of testing the electrical characteristics of a test target light source by comparing the level of voltage or current applied to the light source 11 with the level of the optical signal received by the optical receiver unit 15.

Moreover, the tray 13 according to the exemplary embodiment of the present invention may be provided to have a shape capable of being transported. That is, the light source 11 may be received in the tray 13 to be transported, and subjected to testing during a testing process while being received, without being transferred to a separate socket, or the like.

Furthermore, the light source 11 may be a light emitting diode (LED) package.

Hereinafter, components constituting the testing apparatus according to the exemplary embodiment of the present invention will be explained with reference to the attached drawings.

Continuously referring to FIG. 1, the probe units 14 and the optical receiver unit 15 are arranged to correspond to each of the light sources 11, and may be provided on a one-to-one basis, corresponding to all of the plurality of light sources received in the single tray 13. By doing so, sequentially transferring and rearranging the probe units 14 and the optical receiver unit 15, in order to apply power to each of the plurality of light sources 11 and receive an optical signal therefrom, as in a testing apparatus according to the related art, may be omitted, thereby improving production efficiency. Namely, the probe unit 14 and the optical receiver unit 15 are provided in plural to reduce the physical movements of the probe unit 14, the optical receiver unit 15, and light source 11 as much possible or preferably to remove the movements thereof, thereby allowing for rapidly testing the plurality of light sources 11 by controlling only the delivery paths of the power and the optical signal. A detailed configuration of controlling the delivery path of the signal will be described later.

However, the present invention is not limited to a configuration in which the number of optical receiving units 15 exactly corresponds to the number of light sources 11, and the present invention may provide a testing apparatus including a greater number of optical receiver units 15 than light sources 11 or a testing apparatus including a smaller number of optical receiver units 15 than the light sources 11, while classifying the light sources according to groups to perform testing thereon. However, the number of optical receiver units 15 may correspond to the number of light sources 11 receivable in the tray 13.

The power supply control unit 18 performs controlling on power inputted to the probe units 14 as described above. By doing so, testing of the plurality of light sources 11 may be simultaneously performed by using the single optical properties analyzing unit 19. More specifically, the power supply control unit 18 may allow a plurality of powers to be applied to the plurality of light sources 11, and in this case, the applying of power sources may be performed at different intervals of time, rather than being performed at the same time. That is, at a predetermined interval of time, a power may be applied to one light source 11 corresponding to the predetermined interval of time, and at another interval of time, a power may be applied to another light source 11 corresponding to another interval of time, whereby the plurality of powers may be sequentially applied to all of the light sources 11. In this case, predetermined locations on the tray, in which a plurality of light sources 11 are received, may correspond to the intervals of time at which the powers are applied.

By the applying of power performed at different intervals of time, each of the light sources 11 may be sequentially operated at a predetermined interval of time. Thus, an optical signal according to each of the light sources 11 may also be received at a predetermined interval of time. In this case, the properties of an optical signal received by the optical receiver unit 15 may be tested by the optical properties analyzing unit 19, and a light source from which the received optical signal was outputted, among the plurality of light sources 11, may be determined, that is, the location of the tray on which the light source corresponding to the optical signal is positioned, is recognized by the interval of time at which the optical signal is received.

Consequently, according to this configuration, in performing testing for the plurality of light sources 11, while the number of paths through which optical signals are delivered to the optical properties analyzing unit 19 is maintained to be one, the optical signals respectively corresponding to the light sources 11 are delivered at different intervals of time, thereby allowing for the discrimination of the optical signals. By doing so, the optical properties analyzing unit 19 does not need to test the plurality of light sources 11 in parallel at the same time, and may test received optical signals one by one.

FIGS. 2 through 6 are cross sectional views schematically illustrating various embodiments for the constitution of probe units and trays, in the testing apparatus according to the exemplary embodiment of the present invention. In particular, a tray according to this exemplary embodiment of the present invention may include a receiving part formed to be recessed inwardly such that the light source is seated therein; however the present invention is not limited thereto. Various shapes of the receiving part, capable of receiving the light source, may be adopted.

Referring to FIG. 2, in this exemplary embodiment, a tray 23 and a probe unit 24 are configured in the simplest form. Namely, a light source 21 is received in the tray 23, and the probe unit 24 may be directly in contact with a lead frame 22 of the light source 21, and electrically connected thereto. In this case, a separate circuit component or the like for electrical conduction are unnecessary on the tray, whereby manufacturing of the tray 23 may be facilitated and the costs thereof may be reduced.

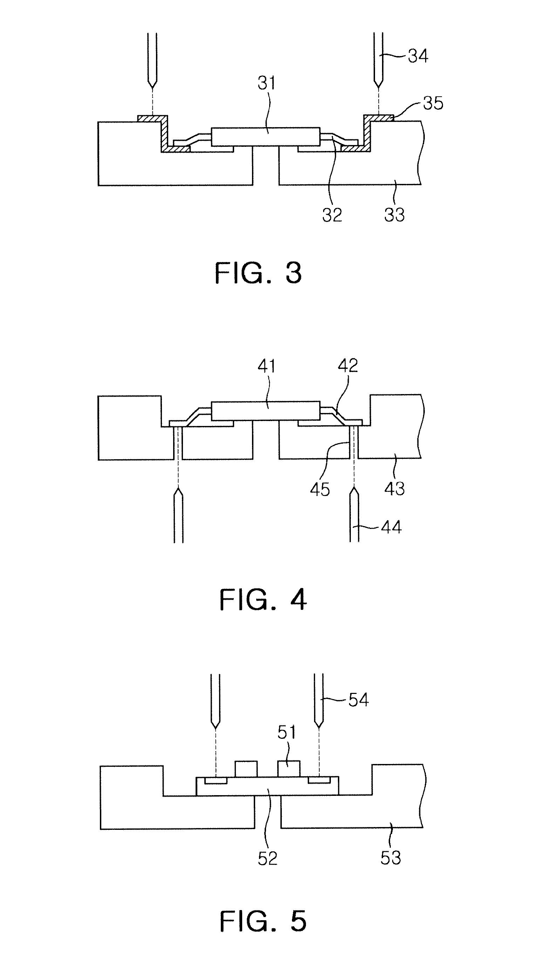

Referring to FIG. 3, in this exemplary embodiment, a tray 33 is provided to have a conductive connection part electrically connected with a lead frame 32 in corresponding to a light source 31 received in the tray 33 and having one end extended to the outside of the receiving part.

By forming the conductive connection part 35 in this manner, even in the case in which the light source 31 and the lead frame 32 may have various shapes, an electrical connection between the light source 31 and the probe unit 34 may be easily secured. Further, physical damage or deformation caused by directly contacting the probe unit 34 with the light source 31 may be prevented.

In addition, the conductive connection part 35 may act to electrically connect a plurality of light sources 31 received in the tray 33, as well as function to simply extend the area with which the probe unit 34 may be in contact. For example, the light sources are configured to be connected in series or in parallel by using the conductive connection part 35 disposed between the light sources 31 received in the same line, whereby a power supply may be simultaneously applied to the plurality of light sources 31 by the single probe unit 34.

Referring to FIG. 4, in this exemplary embodiment, a tray 43 is provided to have a through hole 45 penetrating the area in which a lead frame 42 of a light source 41 received in the tray 43 is seated, in a thickness direction thereof. By doing so, a probe unit 44 may comes into contact with a lower surface of the tray, not an upper surface thereof, whereby the area of the upper surface of the tray 43 may be easily secured.

FIG. 5 has the same configuration as in FIG. 2, except that a light source module including a circuit substrate 52 in which a plurality of light sources 51 are seated, is mounted on a tray 53, instead of the light source according to the foregoing embodiment of the present invention. In this exemplary embodiment, a probe unit 54 comes into contact with an electrode formed in the circuit substrate 52. In this case, a printed circuit board (PCB) may be provided as the circuit substrate. In addition, in this exemplary embodiment, a plurality of light sources are mounted on a circuit substrate. However, the circuit substrate may also be configured as a chip-on-board by mounting a single light source thereon, which may be easily carried out by a person having ordinary skill in the art.

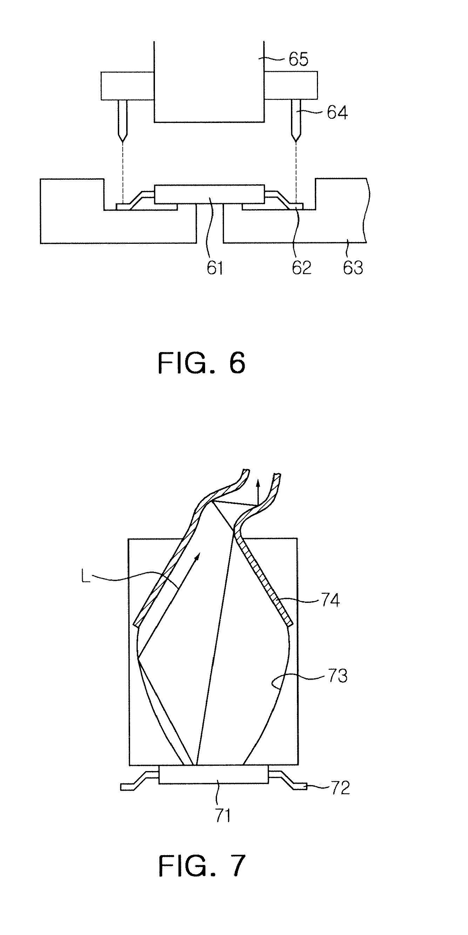

Referring to FIG. 6, in this exemplary embodiment, a tray 63 has a structure in which an optical receiving unit 65 is coupled with a probe unit 64, and the probe unit 64 is arranged to come into contact with a lead frame 62 of a light source 61, while the optical receiver unit 65 is also arranged with the light source 61 to receive an optical signal. By doing so, the tray 63 does not need to have a separate driving part allowing the optical receiving unit 65 and the probe unit 64 to come into contact with the light source and to then be separated therefrom.

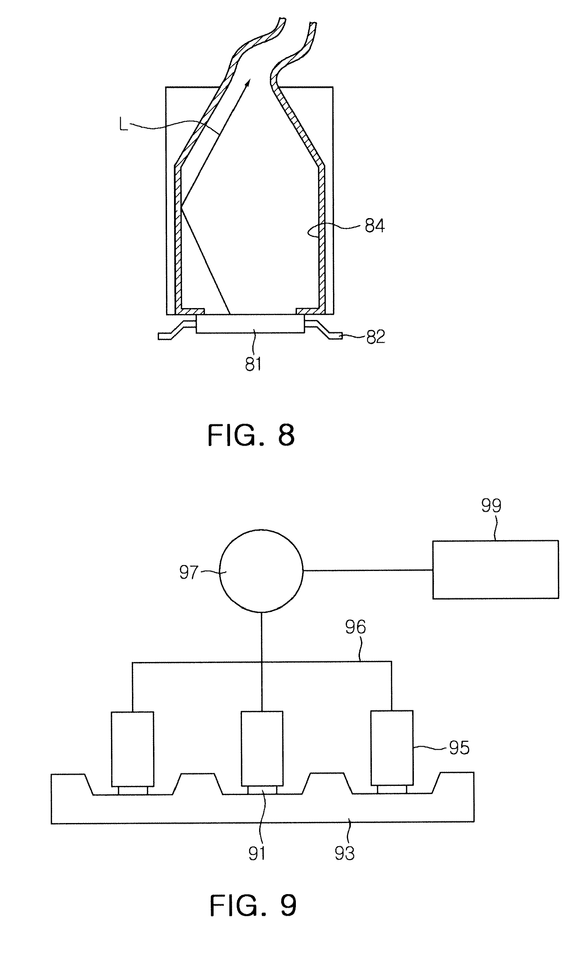

FIGS. 7 and 8 are cross sectional views schematically illustrating the structures of light receiving units receiving light generated from light sources 71 and 81, according to exemplary embodiments of the present invention.

Referring to FIG. 7, an optical receiver unit according to this exemplary embodiment of the present invention may include a reflecting part 73 having a reflecting layer formed thereon such that light (L) coming into contact with at least a partial area on an upper surface of a light source 71 to be emitted in a lateral direction is upwardly reflected, and an optical fiber part 74 guiding light collected in the reflecting part 73 to outside the optical receiver unit through total reflection.

Moreover, referring to FIG. 8, an optical receiver unit according to another exemplary embodiment, the optical receiver unit may be provided to have a configuration in which an optical fiber part 84 is extended to be in contact with a light source 81.

By doing so, preventing light emitted from the light sources 71 and 81 from being reduced within the optical receiving unit may be realized, and the light may be fluently transferred to the optical properties analyzing unit through an optical fiber.

FIG. 9 is a block diagram schematically illustrating a process in which an optical signal received by the light receiving unit is guided to an optical properties analyzing unit, in the testing apparatus according to the exemplary embodiment of the present invention.

Referring to FIG. 9, light emitted from a plurality of light sources 91 received in a tray 93 is received as optical signals from a plurality of optical receiver units 95 disposed in such a manner as to correspond to the plurality of light sources 91, and the received optical signals may be guided to an integrating sphere 97 through the optical fiber. The integrating sphere 97 is a device allowing light emitted from a specific direction to be uniformly diffused throughout an inner sphere thereof to detect the velocity of light in a partial area, thereby confirming the velocity of light in the entire light source. Functions of the integrating sphere and configurations thereof according to the present invention will be easily understood and carried out by a person having ordinary skill in the art.

In particular, the integrating sphere 97 may have a structure in which a plurality of optical signals are guided from the plurality of optical receiver units 95. That is, it is not necessary to provide an integrating sphere for each light source 91, and a smaller number of integrating spheres 97 than light sources 91 may be included, and preferably, the integrating sphere 97 may be included for each tray 93 on a one-to-one basis by recognizing a light source from which the received optical signal is outputted, among the plurality of light sources 91, according to the interval of time at which the optical signal is received. Therefore the constitution of the integrating spheres may be simplified.

Also, in this case, the connection between the integrating sphere 97, the plurality of optical receiver units 95, and the optical properties analyzing unit 99 may be performed by using an optical fiber 96. By doing so, the loss of light caused during a process in which light is guided may be minimized, thereby allowing for more accurate optical properties tests.

Hereinafter, a testing method using the testing apparatus as described above will be explained.

Referring to FIG. 1, a testing method for a light source according to the exemplary embodiment of the present invention may include receiving one or more light sources 11 in the tray 13; electrically connecting the probe units 14 arranged to correspond to the light sources 11; applying power to the light sources 11 by the probe units 14; receiving optical signals from the light sources 11 by optical signal units 15 arranged to correspond to the light sources 11; and analyzing properties of the received optical signals.

In this case, the present invention is not limited to a configuration in which the number of optical receiving units 15 exactly corresponds to the number of light sources 11, and the present invention may provide a testing apparatus including a greater number of optical receiver units 15 than light sources 11 or a testing apparatus including a smaller number of optical receiver units 15 than the light sources 11, while classifying the light sources 11 according to groups to perform testing thereon.

In addition, electrically connecting the probe units 14 with the light sources 11 may be performed in such a manner that the probe units 14 and the optical receiver units 15 are combined to couple with the light sources and to separate from the light sources, all together.

In addition, in the applying of power to the light sources 11, power is controlled to be applied to the individual light sources at different predetermined intervals of time to thereby allow optical signals to be generated at different intervals of time, such that power is sequentially and successively applied to the individual light sources. In this manner, testing may be performed by using sequential signals without unnecessary intervals between the applications of power, thereby improving measuring capability per unit time with regard to the light sources 11.

Moreover, in the analyzing of the optical properties, a corresponding light source 11 is discriminated and recognized by an interval of time at which the optical signal is received, and the recognized light source may correspond to the analyzing result of the optical signal as described above.

Though not illustrated, the testing method may further include classifying the plurality of light sources 11 by discriminating and arranging the plurality of light sources 11 based on results analyzed from the the optical properties analyzing unit 19. Further, the testing method may include a separate testing process in which the level of voltage or current applied to the light source 11 is compared with the level of the optical signal received by the optical receiver unit 15, whereby the electrical properties of the test target light source 11 may be tested.

The tray 13 according to the foregoing embodiment of the present invention may be provided to be transferred. That is, the light source 11 may be received in the tray 13 to be transported, and introduced to a testing process while being received, without being transferred to a separate socket, or the like.

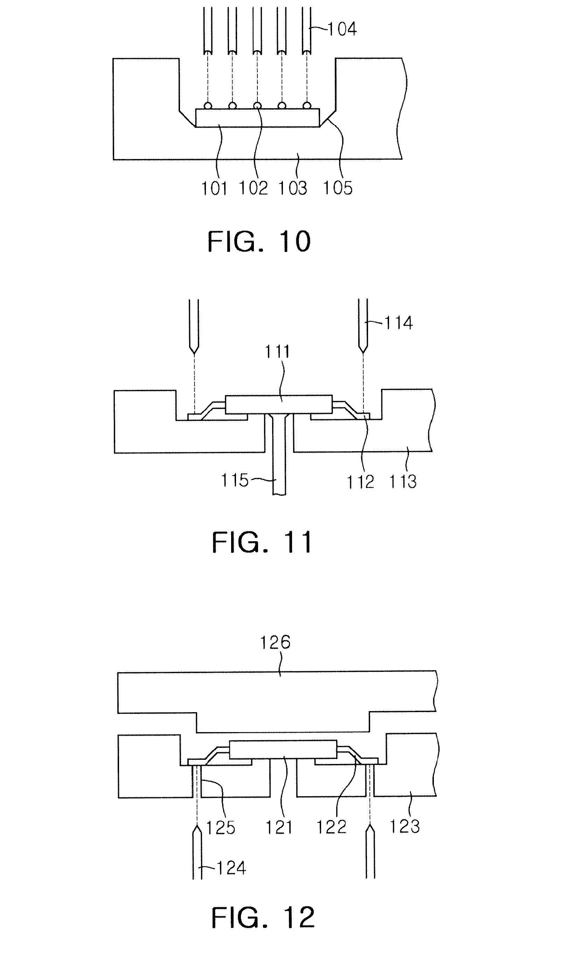

FIGS. 10 through 15 are cross sectional views schematically illustrating configurations of probe units and trays for testing a semiconductor package according to exemplary embodiments of the present invention.

Configurations of probe units and trays shown in the following embodiments may be applied to the testing apparatus according to the foregoing embodiment of the present invention. In particular, similarly to the case illustrated in FIGS. 2 to 6, the tray is provided to have a receiving part recessed inwardly such that the semiconductor package is seated therein, in these exemplary embodiments of the present invention; however the present invention is not limited thereto. A receiving part having various shapes, capable of receiving the semiconductor package, may be adopted.

Referring to FIG. 10, a semiconductor package 101 according to the present invention has an upper surface on which a plurality of solder balls 102 are disposed and a lower surface which is flattened. In this case, a tray 103 may have a structure in which a bottom surface of a receiving part formed on a body of the tray is formed to be flattened while having a width corresponding to that of the semiconductor package, such that the lower surface of the semiconductor package 101 is adhered closely to the bottom surface of the receiving part.

Also, the receiving part may have the bottom surface on which the semiconductor package 101 is received, and side surfaces surrounding the bottom surface. Here, at least a partial area of a boundary at which the bottom surface and the side surface intersect has an inclination part 105 formed thereon such that the width of the receiving part becomes narrower towards the bottom thereof, and the inclination part may be provided as a fixing element. By doing so, even in the case that the width of the semiconductor package 101 is smaller than that of side surfaces of the receiving part, the inclination part 105 may come into contact with edges on the lower surface of the semiconductor package 101, the semiconductor package 101 may be fixedly received in the tray 103.

Referring to FIG. 11, a tray 113 according to this exemplary embodiment of the present invention may include a fixing element 115 in the approximate center area of a semiconductor package 111 received in a body of the tray or the lower surface of the body. Since the semiconductor package 111 is temporarily received, rather than fixed or mounted into the tray, a received position thereof may be misarranged due to external impact or vibrations. In this case, since defects may be caused in arranging, contacting, and receiving the probe unit and the optical receiver unit, the tray 113 may further include the fixing element 115 capable of fixing the received semiconductor package 111 therein, besides fixing due to gravity.

Referring to FIG. 12, a tray 123 according to this exemplary embodiment of the present invention may be provided, in which a semiconductor package 121 is connected with a probe unit 124 from a lower surface thereof via through holes 125 formed in the tray, and a fixing element 126 is included to pressure-support the semiconductor package 121 received in the tray from a upper surface thereof.

The function and effect of the fixing element 126 are the same as those of the fixing element 115 shown in FIG. 7. The fixing method of the fixing element 126, performed by pressurizing and fixing the semiconductor package 121 to the tray 123 is merely different therefrom.

In this case, the surface of the fixing element 126 coming into contact with the semiconductor package 121 is provided with a buffer device. By doing so, damage to the semiconductor package 121 may be prevented.

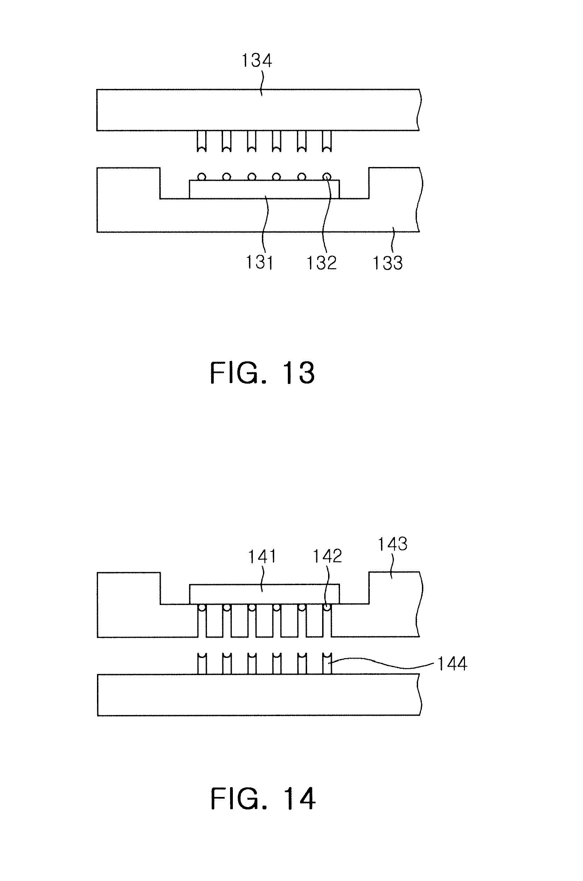

Referring to FIG. 13, a semiconductor package 131 is provided to have a solder ball on an upper surface thereof. A probe unit 134 is disposed above the semiconductor package 131 in such a manner as to correspond to the solder ball 132 of the semiconductor package 131, and the end of the probe unit 134 may have an inwardly concave curved surface so as to correspond to the size and shape of the solder ball 132.

Referring to FIG. 14, a tray 143 according to this exemplary embodiment of the present invention has a through hole penetrating an area of a semiconductor package 141, corresponding to a solder ball 142, in a thickness direction thereof. The through hole is formed to have a larger width than that of the solder ball 142 such that the solder ball 142 is entirely inserted into the through hole. By doing so, the semiconductor package 141 may be firmly fixed into the tray, without a separate fixing element.

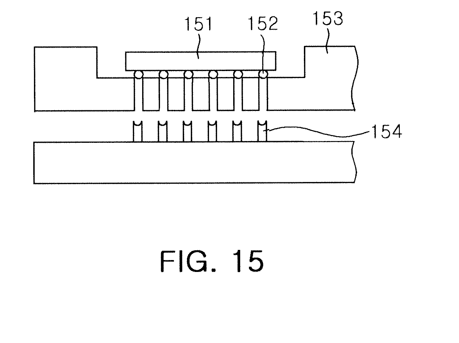

However, the present invention is not limited to this exemplary embodiment, and as shown in FIG. 15, so long as the through hole has a sufficient width through which a probe unit 154 is capable of being passed, for example, the through hole may be formed to have a narrower width than that of the solder ball such that the solder ball 152 is partially inserted into the through hole.

As set forth above, according to exemplary embodiments of the invention, when the tray, the testing apparatus, and the testing method using the same according to the exemplary embodiments of the present invention are used, testing may be performed directly on the tray, thereby obtaining improved testing capability per unit time.

While the present invention has been shown and described in connection with the exemplary embodiments, it will be apparent to those skilled in the art that modifications and variations can be made without departing from the spirit and scope of the invention as defined by the appended claims.

## Claims

1. A testing appratus, comprising:
a tray having a purality of light sources received therein, the purality of light sources outputting light when power is applied thereto;
a plurality of optical receiver units arranged to correspond to the plurality of light sources and receiving the light outputted from each of the plurality of light sources;
a plurality of probe units arranged to correspond to the plurality of light sources and applying power to each of the plurality of light sources;
a power supply control unit selectively controlling power applied to the plurality of probe units; and
an optical properties analyzing unit analyzing properties of optical signals from the light received by the optical receiver units.

2. The testing appratus of claim 1, wherein the power supply control unit controls power such that the power is applied to each of the plurality of light sources at different intervals of time.

3. The testing appratus of claim 1, wherein the optical properties analyzing unit discriminates and recognizes a corresponding light source by an interval of time at which light is received.

4. The testing apparatus of claim 1, wherein the probe unit and the optical receiver unit are integrated.

5. The testing apparatus of claim 1, further comprising a classifier unit discriminating and arranging the plurality of light sources based on results analyzed from the the optical properties analyzing unit.

6. The testing apparatus of claim 1, further comprising an integrating sphere collecting the light received from the optical receiver unit to guide the collected light to the optical properties analyzing unit.

7. The testing apparatus of claim 6, wherein the light received from the optical receiver unit is guided to the integrating sphere.

8. The testing apparatus of claim 1, wherein the optical receiver unit includes a reflecting part upwardly reflecting light coming into contact with at least a partial area on an upper surface of each light source to be emitted from the light source, and an optical fiber part guiding the light reflected from the reflecting part.

9. The testing appratus of claim 8, wherein the reflecting part is formed of an optical fiber and integrated with the optical fiber part.

10. The testing appratus of claim 1, wherein the probe units come into contact with the light sources to apply power thereto.

11. The testing appratus of claim 1, wherein the tray includes conductive connection parts corresponding to the received light sources and electrically connected to the light sources.

12. The testing appratus of claim 11, wherein the probe units come into contact with the conductive connection parts to apply power to the light sources.

13. The testing appratus of claim 1, wherein the tray includes through holes penetrating at least portions of areas in which light sources received in the tray are seated, in a thickness direction thereof.

14. The testing appratus of claim 13, wherein the probe units come into contact with the light sources to apply power thereto through the through holes.

15. The testing appratus of claim 1, wherein the light sources are LED packages.
